# EUROPEAN PATENT APPLICATION

(11) **EP 4 804 074 A1**
(43) Date of publication of application: **09.09.2026**
(21) Application number: 25162293.2
(22) Date of filing: 07.03.2025
(51) Int. Cl.: G06F 30/3323

(54) **VERIFICATION TECHNIQUES LEVERAGING STRUCTURAL ANALYSIS**

(71) Applicant: Siemens Industry Software Inc., Plano, TX 75024 (US)
(72) Inventor: Grosse, Joerg, 83727 Schliersee (DE); Brinkmann, Raik, 81371 Muenchen (DE)
(74) Representative: Siemens Patent Attorneys

(57) **Abstract**

A, preferably computer-implemented, method of verifying a logic function (230, 230a) of a plurality of logic functions (230, 240, 232, 230a, 240a, 232a) of an integrated circuit (100), e.g., a VLSI design, the method comprising the steps of: performing a structural analysis of a logic design (101) implementing the plurality of logic functions (230, 240, 232) for determining a portion (102) of the logic design (101), the portion (102) comprising a plurality of interconnected design elements (311, 312, 314, 313) representing the logic function (230, 230a), generating a design entity (600) of the portion (328) for performing a, preferably formal, verification of the logic function (230).

## Description

Independent of the grammatical term usage, individuals with male, female or other gender identities are included within the term.

### TECHNICAL FIELD

The present disclosure relates to integrated circuits and the design of the same. The disclosure further relates to the verification of integrated circuits, ICs. Integrated circuit design, semiconductor design, chip design, or IC design, is a sub-field of electronics engineering, encompassing the particular logic and circuit design techniques required to design integrated circuits. ICs consist of miniaturized electronic components built into an electrical network on a monolithic semiconductor substrate by photolithography. An IC design enables producing components such as microprocessors, FPGAs, memories (RAM, ROM, and flash) and/or digital ASICs.

In electronic design automation, EDA, software tools are used for designing electronic systems such as integrated circuits and printed circuit boards. The software tools work together in a design flow that chip designers use to design and/or analyze the chips. Since a modern semiconductor chip can have billions of components, EDA tools are essential for their design. A number of software tools are used to describe an IC at various levels of abstraction and/or granularity. Such tools include gate level descriptions, which specify the circuit in very great detail, to high level descriptions written in hardware description languages, HDLs, such as VERILOG or VHDL.

### BACKGROUND

IC design verification is the process of determining whether an integrated circuit exactly implements the requirements defined by the specification of the integrated circuit. As IC designs, also referred to as design (only), become more complex, the likelihood of design errors increases and design verification becomes increasingly difficult and time consuming.

Presently, design verification may be performed using formal verification and/or a simulation model of the design. Formal verification is a mathematical and/or algorithmic solution designed to explore the entire state space of a design. Unlike simulation that tests the design functionality, formal verification proves that an implementation meets certain requirements. Therein, so called assertions, like for example assert, assume and/or restrict, may be used to determine the analysis scope of the formal verification. A design's state space expands geometrically, cycle by cycle, starting from an initial state and examines all possible states. If illegal states are reachable, a bug is found. Otherwise, a proof of the intended functionality is obtained.

The ability to analyze, test, and/or validate hardware circuits and/or system-on-chips is crucial for the design process, since undetected errors incur severe risks with respect to security, safety, and/or potential financial loss. One approach to prevent such errors is to create formal specifications of the properties one expects the design to satisfy, and to verify that they hold in the design. This method is commonly referred to as "formal verification". The most common languages used to express properties are "SystemVerilog Assertions", SVA, and the "Property specification language", PSL, both of which are standardized and used widely in industry.

State space explosion is a significant challenge in the formal verification of designs, e.g. on the Register Transfer Level, RTL, designs. State space explosion refers to the exponential growth of the number of states in a design as the number of state variables increases. For example, if a system has n binary state variables, it can theoretically have 2^n possible states. As more state variables are added and the complexity of the design increases, the number of states grows exponentially, making it impractical to explore all possible states exhaustively. In particular formal verification aims to prove or disprove the correctness of a design by exhaustively examining its states and transitions. Thus, as mentioned, as the complexity of the design increases, the number of possible states can grow exponentially, leading to what is known as state space explosion. This phenomenon can severely impact the process of verification, leading to issues such as non-convergence or impractical verification runtimes.

### SUMMARY

The primary impact of state space explosion is on computational resources. Memory and processing power required to store and analyze all possible states that may become prohibitive. Modern verification tools may thus run out of memory or take an impractically long time to complete the verification process.

Also due to the enormous number of states, the verification process may fail to converge to a result. Non-convergence means that the verification tool cannot definitively prove or disprove the correctness of the design within a reasonable amount of time. This can leave designers uncertain about the reliability of the IC design.

As IC designs become more complex, the scalability of verification tools becomes a major issue and techniques that work for smaller designs may not scale effectively to larger, more complex designs.

It is thus a desire to conquer the ever-expanding complexity of IC designs and make efficient use of the available tools and resources.

According to a first aspect a, preferably computer-implemented, method of verifying a logic function of a plurality of logic functions of an integrated circuit, e.g., a VLSI design, is proposed. The method comprising the step performing a structural analysis of a logic design implementing the plurality of logic functions for determining a portion of the logic design, the portion comprising a plurality of interconnected design elements representing the logic function. The method further comprising the step of generating a design entity of the portion for performing a, preferably formal, verification of the logic function.

According to a second aspect a computer program, comprising program code is proposed. When executed, the program code performs the methods steps according to the first aspect.

According to a third aspect, an apparatus, preferably comprising a processor and a memory, for performing the method steps of the first aspect is proposed. The apparatus preferably comprising the computer program according to the second aspect, e.g., storing it in said memory.

### Brief description of the drawings

Figure 1 shows verification process comprising a formal verification techniques.
Figure 2 illustrates a dual core lock-step safety feature of an integrated circuit design.
Figure 3 shows data paths of an integrated circuit design to be verified using secure path verification.
Figure 4 illustrates a first step of an extraction of (a logic function of) a subpart of an integrated circuit design.
Figure 5 illustrates a second step of an extraction of a subpart of an integrated circuit design.
Figure 6 illustrates a structural design partitioning.
Figure 7 shows a first flow diagram illustrating steps of a secure path verification.
Figure 8 shows a second flow diagram illustrating steps of a secure path verification comprising a structural partitioning.
Figure 9 shows further details of a secure path verification comprising a structural partitioning.
Figures 10 to 14 show exemplary steps of verifying a design entity comprising a logic function.

### Detailed description

The integrated circuit, IC, design and manufacturing process involves several steps to create complex electronic circuits on a small semiconductor chip: In the realm of IC design verification stands as a cornerstone for ensuring design correctness. In particular formal verification may comprise translating an IC design, e.g., in the form of an RTL design, into a netlist representing an electronic circuit composed of digital gates like AND, OR, flip-flops, and/or latches. These gates are modeled to match their real-world counterparts' behavior. The integrated circuit 100 may thus comprise components such as transistors, resistors, capacitors, and interconnections.

The process starts by defining a specification of the IC 100. A designer creates and/or details requirements, capabilities, and/or features, i.e. one or more functions, such as data processing algorithms to be performed by the integrated circuit, often using one or more electronic design automation, EDA, tools, for example by way of a function block diagram and/or one or more flowcharts.

From the specification a logic design in a hardware description language, like VHDL (Very High Speed Integrated Circuit Hardware Description Language) or Verilog, may be created, e.g., by transforming the specification into a logic design. To that end, a register-transfer-level, RTL, description that can theoretically carry out the specification is created. The RTL design process may comprise a high-level synthesis during which a high-level description, e.g., said specification, of the IC 100 is transformed into an RTL description. This involves translating the specification, e.g., specified in a high-level language such as C or C++, into an equivalent RTL description in a hardware description language, HDL, like VHDL or Verilog. The RTL description or RTL code is a high-level representation of the IC 100, and is used to describe the one or more functions of the IC 100. In RTL design, registers are used to hold the inputs, outputs, and/or intermediate results of logic operations performed. This logic design comprises the behavior and functionality of the IC. Here formal verification may be used to verify the logic design of the IC. In RTL design such operations are the logic functions that manipulate and process the data stored in registers. These operations are the building blocks of digital systems and are responsible for implementing the desired functionality of the system (comprising the IC 100). The RTL code describes the data flow and/or the operations of the IC 100. Operations in RTL design can be broadly categorized into two types: logical operations and arithmetic operations. The first, logical operations, perform bitwise evaluation and modification of the data stored in registers. Logical operations, like AND, OR, NOT, XOR, and shift, are created by defining the logical behavior in the HDL. For example, an AND operation can be represented in VHDL or Verilog. These logical operations represent logic gates in the hardware. The second type of operations in RTL design are arithmetic operations. They take the data in registers and perform, e.g., add, subtract, multiply, and divide operations. They are represented in the HDL with standard mathematical operators.

Subsequently a verification on the RTL level, where the correctness of the RTL design is checked, may be performed. This may involve simulating the RTL design to ensure it behaves as expected, and/or formally verifying the RTL design to prove its correctness. Simulation tools may be used to conduct timing analysis and/or track register values throughout the IC design. The design may thus be checked at the register-transfer level to ensure there are no timing issues across the integrated circuit and that the operations produce the expected outputs. Input vectors are applied, and the resulting output vectors are compared to the expected results. The inputs and outputs are usually represented as waveforms so that a user, such as the design engineer, can visually inspect the system's behavior.

For formal verification a set of behavior expectations of the RTL design are determined in the form of mathematical expression or mathematical algorithms that explore the entire operating space of the IC design. The results are then mathematically evaluated to verify correctness. Once the IC's design has been fully verified, RTL synthesis is used to convert the HDL code representation of the RTL design into a gate-level netlist. That is, the logic design is then translated into a detailed circuit design, where the components are laid out and interconnected.

Further steps in the IC design and/or manufacturing process may comprise a design layout, where the IC design is converted into a physical layout that determines the exact placement and/or dimensions of the components and their interconnections on the semiconductor chip. This layout is created using specialized layout tools, i.e. EDA tools. Furthermore, a mask may be generated, where one or more masks are created based on the layout design. Masks are patterns that define the shapes and locations of various features on the IC 100. These masks are used in fabrication to transfer the circuit design onto the silicon wafer. For the wafer fabrication the one or more masks may be used to create the desired patterns on the silicon wafer, which involves depositing and etching various layers, doping, and creating transistor structures. Multiple ICs are fabricated on a single wafer. Once the wafer fabrication is complete, the individual ICs are separated and packaged into suitable housing to protect them and provide electrical connections. Packaging also involves the attachment of leads or balls for external connections. The packaged ICs undergo various electrical tests to meet the design specifications. Testing again involves a (functional) verification, performance evaluation, and reliability assessments. Then the IC are mounted onto printed circuit boards (PCBs), which provide electrical connectivity and mechanical support.

Hence, in general, verification means to generate proof that an IC design matches a (given) specification. Formal verification may be understood as a systematic process that uses mathematical reasoning and mathematical proofs (i.e., formal methods in mathematics) to verify that the IC design satisfies its desired properties, behavior, or specification (i.e., the system implementation is a faithful representation of the design).

RTL verification is the final stage in the RTL design methodology, where the correctness of the RTL design, also referred to as RTL description or RTL code, is checked. This stage is crucial to ensure that the RTL description accurately represents the intended behavior of the digital system, i.e. said IC, and meets the desired requirements. As mentioned, there are two main methods used in RTL verification: simulation and formal verification.

Simulation is a (dynamic) verification method where the RTL design is tested by applying a set of input vectors and observing the resulting output vectors. The input vectors are typically derived from the system's specifications and are designed to exercise all the functional aspects of the system. The output vectors are then compared with the expected results to check the correctness of the design.

Formal verification is a (static) design verification method that mathematically proves the correctness of the RTL design. This involves expressing the intended behavior of the system as a set of formal properties, and then using a formal verification tool to prove that these properties hold for the RTL design. To that end, mathematical algorithms exhaustively explore the state space of the IC design and prove the correctness of the formal properties.

RTL partitioning may be used to manage the complexity of large RTL designs. RTL partitioning comprises dividing, (un)grouping, and/or promoting design elements into smaller, more manageable parts, or partitions, each of which can be designed and verified independently. This not only simplifies the design process but also allows for parallelism, where different partitions can be designed and verified by different designers or teams at the same time. Partitioning can be done in several ways, depending on the requirements of the design. One method is functional partitioning, where the design is divided based on its functional blocks, such as processor core, memory, and input/output, I/O. Partitioning is also possible at the netlist level but the IC 100 at the netlist level has much more objects than at the RTL, so partitioning may take much longer CPU time. Because minimum objects of a netlist circuit are cells or gates, it is difficult to partition the circuit taking functional units into consideration. Partitioning may involve the partitioning of the specification, followed by the synthesis of each partition segment on one or more chips. For hierarchical partitioning the design is divided into a hierarchy of partitions. This is often used in complex designs. Physical partitioning may be performed based on the physical characteristics of the design, such as low-power domains or clock domains. Thus, e.g., in hierarchical partitioning, partitioning is done first, followed by synthesis of each partition.

However, the problem of identifying the design elements that carry out and/or determine the correct functioning of the integrated circuit and thus to be considered for the purpose of verification still persists, e.g., even when employing partitioning on the RTL level, and in particular for hierarchical partitioning. This is true since there may be design elements of other RTL partitions that influence with the behavior of the RTL partition under test, or the correct functioning of the IC.

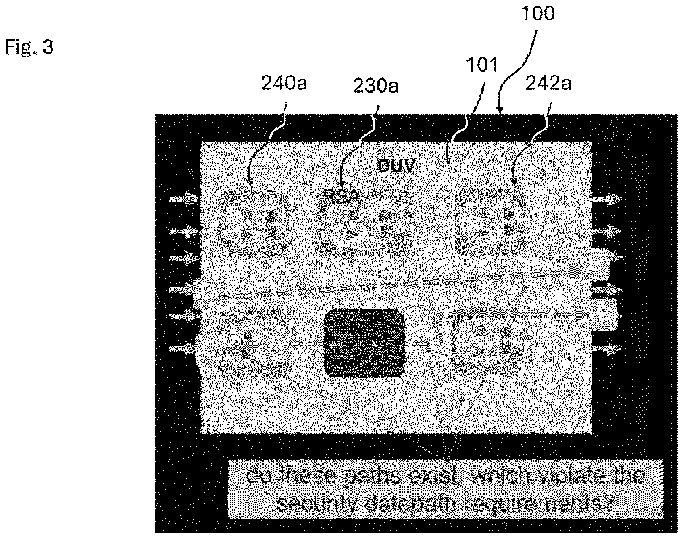

It is thus proposed to determine a portion comprising design elements on the logic level, i.e. based on the one or more logic functions of the integrated circuit. That is, the integrated circuit may be described by an (overall) logic function, which for example may comprise one or more logic functions, such as RSA encryption as shown in Figure 3.

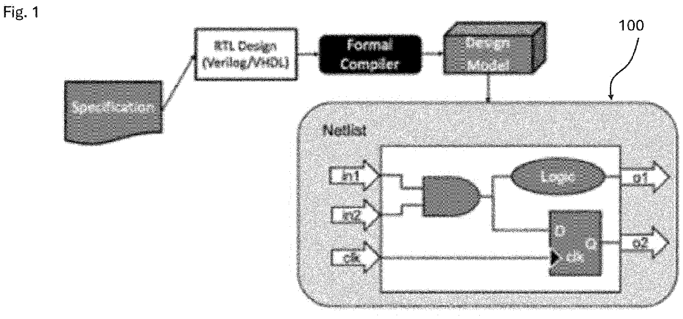

As shown in Figure 1, a formal model may be created, e.g., based on the IC design on the RTL level. The formal model creation, i.e. referred to as design model in Figure 1 may comprise translating the IC design (from the RTL level) into a formal model, or design model, suitable for (a formal) analysis and/or verification. Subsequently one or more properties may be specified. This property specification may comprise defining properties that the IC design must satisfy, e.g., expressed in, for example temporal, logic (expressions). Then a formal tool may be used to prove that the design adheres to these properties. It should be understood, that the logic design of the integrated circuit 100 may be provided in the form of said RTL design (also referred to RTL description), the formal model (also referred to as design model), and/or a netlist.

For formal verification a logic design or design model, as termed in Figure 1, may be used. As mentioned, the logic design may comprise one or more logic function. Therein gates are represented in a simplified manner. For example, a real gate model includes propagation delay and voltage/impedance ranges, whereas a formal model ignores propagation delay and/or operates on a truth table. Formal verification measures time in cycles rather than conventional units like microseconds or nanoseconds. Inputs change at the beginning of cycles, ensuring the netlist's stability during each cycle. This approach simplifies the timing analysis by treating the clock signal as a square wave with periods measured in cycles. Furthermore, propagation delay may be disregarded in such a formal model, i.e. the logic design, meaning input changes result in immediate output changes. This simplification makes it easier to analyze, e.g., the netlist, over time, focusing on how inputs change over cycles rather than precise timing. Properties are central to formal verification. They monitor signals in the IC design, e.g., the netlist, and determine if specific behaviors occur.

Hence, a formal model, i.e. logic design or design model, may ignore propagation delay and operates on a simplified truth table, i.e. on the logic level, and may correspond to the logic design as described herein. Thus, propagation delay is disregarded in formal models, meaning input changes result in immediate output changes. This simplification makes it easier to analyze the netlist over time, focusing on how inputs change over cycles rather than precise timing.

For the formal verification a hardware verification language, HVL, may be used, based on which statements, such as assert, cover, and/or assume, the design can be checked. Asserts, which ensure that behaviors never occur, are crucial for identifying bugs. If an assertion evaluates to false, a counter-example is generated, highlighting the violation. Conversely, if an assertion holds true across all scenarios, it is proven. Covers, confirming behaviors that must occur, ensure that desirable behaviors can occur. Formal tools attempt to find scenarios where the cover property is true. If none exist, the cover is deemed unreachable, indicating a potential design flaw. Assumes, define invalid behaviors, guiding the formal tools' analysis.

Returning to the IC design in the form of a netlist, the state of a netlist is determined by signal values at a specific cycle. If signals are binary, the total number of states is 2N, (N is number of signals). Introducing logic constraints, such as AND gates, reduces the number of reachable states by eliminating invalid combinations. Hence, adding logic constraints simplifies the state space by removing unreachable states. Similarly, assumptions guide formal verification tools by eliminating invalid states, making the verification process more efficient. Hence, a constraint and/or and assumption are rules that dictate a placement or timing restriction for the implementation.

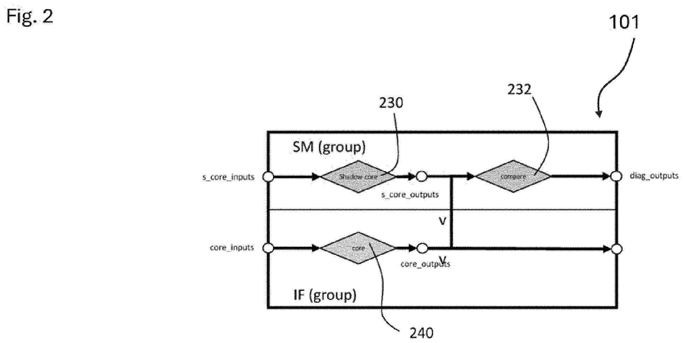

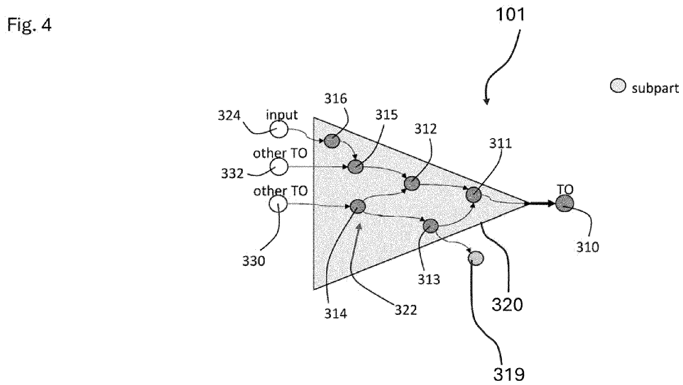

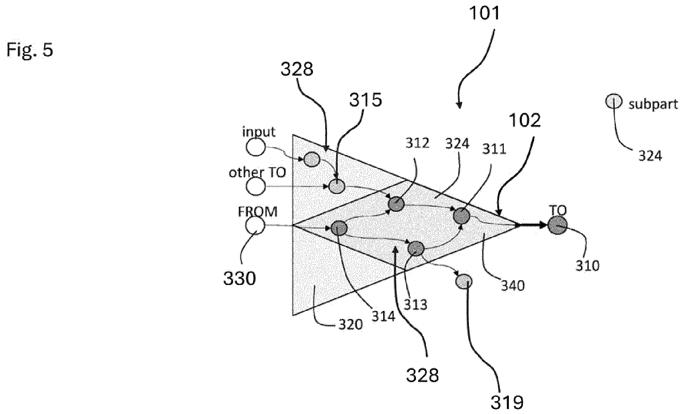

Figure 2 illustrates a lock-step core safety feature of an integrated circuit design. Core inputs are provided to the core 240 in the intended function group, i.e. a first logic function. Shadow core inputs are provided to the shadow core 230 in the safety mechanism, i.e. a second logic function. The shadow core outputs and the core outputs are compared in the comparator 232, i.e. a third logic function, in the safety mechanism to produce diagnostic outputs. However, as for example shown in Figures 4 and 5, some logic, for example in the form one or more design elements, may remain unprotected by such a safety mechanism, or mitigation mechanism in general, e.g., security. Design elements may include, for example, bits, states, ports, signals, wires, gates or cells. Accurate extraction of a subpart, e.g., implementing said one or more logic functions, or set of design elements, is non-trivial. Extraction of a subpart and determination of where the safety mechanism or protected logic begins and/or ends is crucial for efficiently verifying the IC design. As described herein, in particular in connection with Figures 4 and 5, an EDA tool, for example a verification tool, e.g. executed by a processor, may, for example automatically, generate a first set of design elements by intersecting two transitive cones of influence, wherein a first cone of influence is a transitive fanin cone of influence starting from a first point ("TO elements") and a second cone of influence is a transitive fanout cone of influence starting from an second point ("FROM elements").

Safety-related and thus critical functions, e.g., in the auto-motive industry, often feature dualcore lockstep architectures. This is a technique to prevent uncontrolled failures. The two cores operate on the same input (stimuli), denoted as core input in Figure 2, though there might be a delay of a few clock cycles to achieve temporal diversity and reduce the risk of faults causing the same effects on both cores 230, 240, e.g. implementing the one or more logic functions. The cores 230, 240 may be implemented on a single IC and/or may form a first and a second subpart of the IC. A comparator 232, comprising logic elements, and also implemented on the IC, re-aligns the outputs of the two cores and raises an alarm should they be different. The comparator 232 may be understood as a subpart and/or may be verified using formal verification, as proposed herein. If the comparator 232 is verified as part of the IC, a fault injection technique can be applied to inject faults. At IC level, a structural analysis and/or formal connectivity checking may be used to verify that the appropriate outputs of the first and second subpart 230, 240, along with reset, clock, and/or other system-level control signals, are correctly wired to the comparator 232 inputs, while the comparator 232 alarm output is correctly wired to the safety control unit and/or fault logging registers. In case of an alarm, it may not be possible to know if one of the subparts 230, 240, 232 in particular the cores/subparts 230, 240 still operates correctly. The verification of the comparator 232 is a critical task, and in particular safety related and/or safety critical systems, or to ensure system security.

Figure 3 shows data paths of an integrated circuit design to be verified using secure path verification. A secure path verification verifies that only specified paths can be taken and/or that security or safety-critical design elements, e.g., as destinations, such as for example storage elements can be reached through paths. The IC design may thus comprise one or more, e.g., security related, logic functions 240a, 230a, 242a, for example an implementation of the RSA algorithm. Thus, (secure path) verification proves, e.g., using formal prove engines, that for example secure data remains secure. Such secure path verification may comprise as shown in Figure 3, that secret data does not leak on a path between (primary) input A and (primary) output B. Furthermore, integrity of the IC design can be checked, by verifying the data from primary input, e.g., point C should not overwrite secret data at point A. It may further be verified that there is no sneak path exist, e.g., a combination between confidentiality (sneak-out) and integrity (sneak-in). Furthermore, secure path verification may comprise a check for data inversion where it is verified that a secret at D should not reach port E without encryption. Points A, B, C, D, E may be design elements. Thus, a formal verification tool may receive register-transfer level description comprising a specific secure area (memory or registers), and may prove that secure data can't be read illegally, i.e. there are no leaks, that the secure data can't be illegally overwritten, and/or that the secure data remains secure in case of faults or failure, or even deliberate tampering.

Figure 4 illustrates a first step of an extraction of a subpart (corresponding to, or implementing a logic function) of an integrated circuit design, comprising a fan-in cone of influence, and Figure 5 illustrates a second step of an extraction of a subpart of an integrated circuit design comprising a fan-out cone of influence overlapping the fan-in cone of influence. Subpart, portion and partition are used interchangeably herein. Subpart, portion and partition thus represent interconnected design elements within a logic design of an integrated circuit.

The fan-in for a design element, i.e., logic element, is determined by the number of other design elements, e.g., logic elements, connected to its input(s). Thus, when a design element like a buffer has high fan-in, it means that it's being driven by a large number of design elements, or logic elements. A fan-in thus may refer to the number of inputs a logic element can accept. It indicates how many separate signals can be fed into a single logic element. A design with high fan-in can process multiple input signals, allowing for complex logic operations in a single component. As shown in Figure 4, the subpart 322 initially is identified as design elements 311, 312, 313, 314, 315, 316 within the transitive fanin cone of influence 320. The cone of influence 320 stops at TO elements 330, 332 of other subparts and other primary design input(s) 334.

Similarly, the fan-out for a design element, i.e., logic element, is determined by the number of other design elements, e.g., logic elements, connected to its output(s). Thus, when a design element like a buffer has high fan-out, it means that it's capable of driving a large number of design elements, or logic elements. A latch is a design, or logic element, that can sample and hold a binary value. But unlike a flip-flop, which is edge-triggered, the latch is level-triggered.

As shown in Figure 5, the subpart 322, cf. also Figure 4, also contains potential residual logic, referred to collectively as subpart_write 328, that controls the subpart 324. The design element 315 that writes to elements in the subpart 324 can be referred to as a "write bit" 315. These write bits are in the direct fanin of elements composing subpart 324 and may be determined by way of the structural analysis.

Furthermore, the subpart_write 328 may be considered as the transitive fanin cone of write bit 315 that does not include TO or cone elements of other subparts. The processor identifies or extracts the subpart_write 328 (i.e. one or more logic elements or design elements) for example as potential residual logic, or logic which controls a secure path. Still further, as shown in Figure 5, the processor also identifies all basic design elements 319, called "read bits," which are in the direct fanout of subpart 324 and are not TO element 310 or direct fanout of TO element 310. In other words, these read elements are elements that are not in the sub-part but read other elements in the sub-part. These read elements are for example not protected by a safety mechanism or subject to a potential security leakage.

As a result, the subpart may be identified within the logic design. The subpart may comprise a plurality of interconnected design elements. The subpart may perform a logic function from a plurality of logic functions implemented by the logic design. The interconnected design elements may thus represent a logic function from said plurality of logic functions. Thus, the subpart may be identified as a portion of the logic design and a design entity may be generated for performing a, preferably formal, verification of the logic function, i.e. of the portion representing the logic function, as e.g., identified based on the structural analysis.

A design entity can be a top-level design entity, which is a design entity that is the root of a design hierarchy, or a lower-level design entity (or, subdesign). A design entity can be used to instantiate one or more lower-level design entities, and e.g., be the parent for the one or more lower-level design entities. Design entities may refer to one or more logic function. Hence, a design entity can comprise a plurality of interconnected design elements. A design entity may thus comprise at least one primary input and at least one primary output. A design entity can thus be understood as a primitive, megafunction, macrofunction, or state machine, which for example can be represented by either a name or a symbol, for example in a design file.

Hence, a design entity may be determined that represents one or more logic functions (of the plurality of logic functions or plurality of design entities). Thus, any such design entity may be derived from an original design entity. The original design entity may be a collection of one or more design entities. A new, or derived, or isolated design entity may thus be independent of original design hierarchy.

A design entity may be stored in a (preferably non-transitory), e.g., volatile and/or non-volatile (computer) memory, such as a RAM, random access memory. A design entity may comprise or may be characterized by or may be associated with a file (path) name, which for example provides a full path name of the file that contains the design entity. The design entity may comprise or may be characterized by or associated with a file type of the file that contains the design entity. A design entity may comprise or may be characterized by or associated with a library or library element which identifies the file comprising the design entity. A design entity may be created based on an EDA tool used to create the file. A design entity may comprise or may be characterized by or associated with a date and time of the most recent modification to the file and/or design entity.

The design entity may be regarded as a hardware abstraction, e.g., in VHDL it is the primary hardware abstraction. The design entity represents a portion of a hardware design that has well-defined inputs and outputs and performs a well-defined function. A design entity may represent an entire system, a subsystem, a board, a chip, a macro-cell, a logic gate, or any level of abstraction in-between. The top-level block in such a hierarchy is the design entity itself; such a block is an external block that resides in a library and may be used as a component of other designs.

It is thus proposed that that design entity representing the logic function, as, e.g., determined based on said structural analysis, may comprise or may be characterized by or associated with at least one primary input and least one primary output, e.g., in the form of one or more design elements, for example said at least one first and at least one second design element. It is thus proposed to generate or create a new design entity (e.g., replacing or instead or in addition to an original design entity) having primary inputs and/or outputs. The original design entity for example comprising the implementation of the plurality of logic functions of the integrated circuit. The original design entity may be the design entity that serves as the starting point of the structural analysis. Hence, the read bits and/or write bits (of the original design entity) may become (part of) the primary inputs and/or outputs of the (newly generated) design entity.

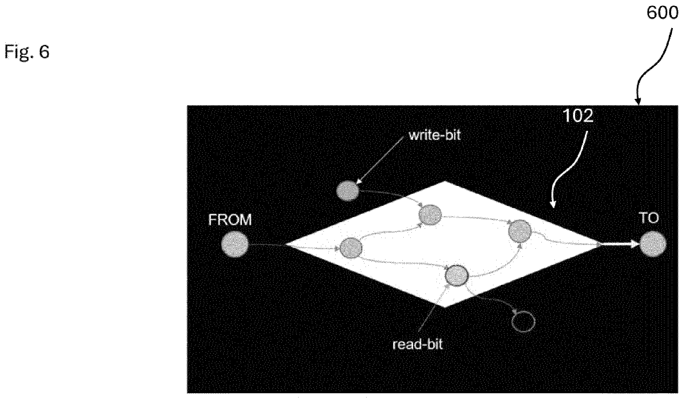

Figure 6 illustrates a structural design partitioning comprising a plurality of interconnected logic elements that form (part of) a design entity 600. The design entity 600 may be determined based on a structural analysis of the IC design. The design may thus comprise the portion 102 of interconnected design elements. In IC design, interconnect refers to the layers of metal or conductive paths that connect different components or sub-circuits on a chip, thus the term interconnect instead of simply connect was chosen. It is proposed to generate a design entity 600 for such a portion of interconnected design elements. Furthermore, it is proposed that the FROM bit(s) 330 and the one or more write bits 315 (and/or 316 (cf. Figure 4)) become a primary input of the design entity and for the one or more read bits 319 and the TO bit(s) to become the primary output of the design entity 600. As the case may be, the read and/or write bit may be part of the design entity. As mentioned herein, the term bit is used herein to refer to design elements, such as one or more logic gates, representing a logic function of the IC (design). However, the case may appear where the read or write bits are not explicitly included in the design entity of that logic function, but for example only the one or more design elements directly connected to the read and/or write bit(s) are included in the design entity. In any case, one or more constraints (or constraint candidates) and/or one or more path propagation checks may be determined that take the read and/or write bits into consideration when performing (formal) verification of the design entity 600.

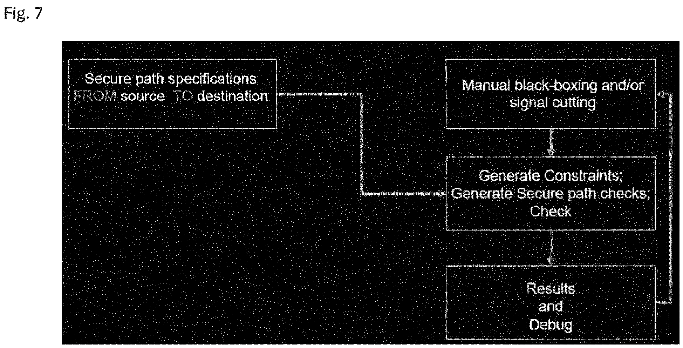

Figure 7 shows a first flow diagram illustrating steps of a verification. In the embodiment shown a secure path verification is performed. For performing such a verification, logic elements identifying source and destination of the secure path within the IC design are determined. Thus, the logic function within the IC design needs to be determined. Subsequently constraints and one or more path (propagation) checks to be performed may be determined. The verification may then be performed for the one or more checks and/or constraints. Since the IC design may be too large to be checked in reasonable time and/or in order to conquer the complexity of the IC design, the design may be partitioned, e.g., manually and/or with the help of the partitioning methods described herein, or as comprised in the prior art, for example in order to identify a logic function. Furthermore, signal cutting may be performed which refers to the practice of intentionally breaking or disconnecting a signal within the IC design in order to isolate and/or control (only) specific parts of the IC during verification, i.e. by the verification tool. Such signal cutting may be for (formal) verification, equivalence checking, and/or debugging. Thereby it can be determined how different parts of an IC behave, i.e. independent of each other. Foremost however, signals may be cut to simplify state-space exploration of the IC design and/or to create specific test conditions. Thus, the verification, i.e. execution of the verification tool can be performed based on a reduced IC design within reasonable time. As a result, a result of the verification may be obtained, e.g., whether the IC design satisfies the checks given the constraints generated. Furthermore, debugging information may be obtained relating to the IC design, e.g., a counterexample may be output, by the (formal) verification tool. Based on such result the manual partitioning, comprising techniques such as black-boxing and/or signal cutting may be repeated, in order to check other or amended partitions of the IC design.

During, e.g., security, verification, portions of the IC design may be black-boxed. Such black boxes may comprise a special qualification about whether data is allowed to go through the black-box or not. This allows to select black-box modules and tune the verification so only meaningful paths are found. Such black-boxing was necessary to guarantee the feasibility of this verification while still keeping results sound by restricting the verification to the remaining parts of the IC design.

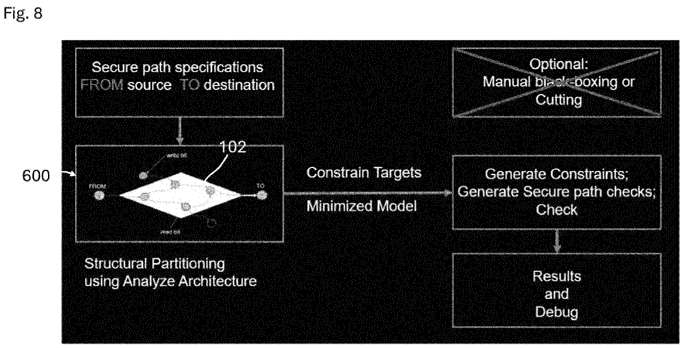

Turning to Figure 8, another flow diagram illustrating steps of a secure path verification comprising a structural partitioning is shown. As shown therein, the step of manual partitioning, i.e. black boxing and/or signal cutting can be avoided. As the case may be, the manual partitioning or signal cutting may nonetheless be performed in addition to the structural analysis. As shown in Figure 8, starting out with an original and/or unrestricted IC design and/or original design entity, a structural analysis may be performed. To that end, the FROM and TO bits, or design elements in general, may be identified, e.g., either by a user or by automatically identifying said design elements, for example as the input and/or output of a (logic) function (of a plurality of (logic) functions implemented by the IC design). As before, the verification may relate to a secure path verification. Thereupon, a structural analysis may be performed such as described herein. Having identified the portion 102 comprising a plurality of interconnected design elements representing the logic function a design entity 600 for the portion may be generated. The design entity 600 may serve for verifying the portion 102 comprising a plurality of interconnected design elements representing the logic function. The design entity 600 may be stored in a file format and/or may be identified, e.g., within the original (and larger) design, by way of primary inputs and/or outputs that serve for the verification tool to check, test or verify whether the design entity suffices and/or exactly implements one or more requirements, e.g., as defined by or derived from the specification of the IC, for example by one or more properties (to be asserted). That is, such a design entity 600 may be input and/or serve as input of a verification tool and/or may form the basis for the verification by the verification tool. Hence, based on the design entity generated, referred to as minimized model in Figure 8, since it contains less logic elements and thus a smaller state space than an original design entity (of the (overall) IC), a verification may be performed, e.g., by said verification tool. To that end, and e.g., in addition to the reduced and or minimized design entity, constraints may be generated to ensure rules or limitations are employed on signals or conditions to ensure the verification is efficient, meaningful, and/or focused on valid scenarios. Subsequently, a verification, such as a secure path verification may be performed based on the design entity. As a result, a verification result, e.g., whether or not the design entity suffices the checks employed may be obtained and the IC design in the form of said design entity may be debugged, e.g., an eventually found counterexample may be remedied by amended the IC design, for example, by adding, removing and/or reconfiguring the design elements of the IC design, e.g., of the design entity. In addition one or more secure path checks, for example in the remaining or residual design may be determined and/or performed. That is, one or more path checks may be performed in the original design entity comprising, and preferably starting from the one or more read bits. As the case may be, the original design entity or a residual design (i.e. the original design entity minus the design entity representing the logic function) may be used to that end.

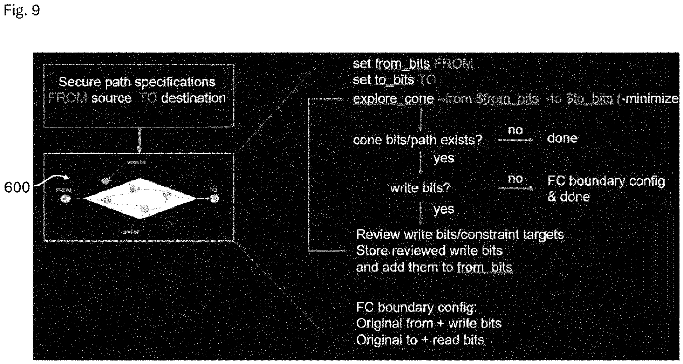

Now turning to Figure 9 further details of a verification comprising a structural partitioning for identifying a reduced or minimized design entity 600 are shown. As before, a secure path verification is considered as an exemplary example. Hence, a first and a second design element are determined, i.e., said FROM and TO bits. Said first and/or second design element may be determined from and/or within the original design entity (of the overall IC design, or a predetermined partition of the IC design, e.g., also given as a design entity). Thereupon, a structural analysis is performed in order to identify a plurality of interconnected design elements representing a logic function (between the FROM and the TO bit). This is exemplified by the code shown in Figure 9, referring to setting the FROM and TO bits as the first and second design element, i.e., to_bits and from_bits. Then, an exploration, e.g., in the form of a structural analysis, for example comprising a path propagation analysis, of the IC design between the from_bits and the to_bits, i.e., the first and second design element may be performed. If no path between the FROM and the TO element exists, then there is also no unsecure path and thus the routine can be terminated. If there is a path between the FROM and TO element, it is checked whether said path comprises one or more of said write bits that that writes to elements in the path and thus may influence the signal over the path, i.e., may control one or more design elements. If there is no such write bit, the routine may (again). One or more design entity boundaries may be set and/or determined, e.g., in the manner just described. Thereby the scope or limits of what aspects of the IC design are monitored for formal coverage during a, e.g., subsequent and/or functional and/or formal, verification may be set. Hence, a design entity defines what is considered within the verification scope of the verification tool. However, if there are one or more write bits, the write bits found may be added to the from_bits, i.e., these write bits may be considered as additional primary inputs of a design under verification, e.g., by said verification tool. It should be understood, that there may be a chain of one or more write bits of which one or more may be added as primary inputs to the new design entity. Hence, thereby the primary inputs of a design entity comprising a plurality of interconnected design elements representing the logic function may be determined. The plurality of interconnected design elements between the first and second design element may then further be explored until all write bits are found, and preferably added to the from_bits, i.e., then used as primary inputs of the design entity. Thus, one or more write bits may be determined in a path from a first write bit (directly controlling one or more design elements within a cone of influence of the FROM an/or TO elements) up to a primary input of the original design entity. Hence, one or more bits which drive write bits might be used as new primary inputs (of a design entity). These one or more new primary inputs may be the write bits determined by a structural analysis, e.g., path propagation and/or a cone of influence analysis. It should be noted that the term write bit (or read bit) is used herein interchangeably with the term design element, and the term (write/read) bit is used as exemplarily only. The same may be performed for the read bits, e.g., instead or in addition to the write bits. As a result of the structural analysis, a design entity configuration may be obtained that comprises e.g., in addition to the original from_bits FROM also the write bits as identified by the structural analysis. The same applies for the to_bits which may in addition to the original destination design element TO also comprise the read bits found by way of the structural analysis (up to the original destination design element TO, or up to the primary output of the original design entity). Hence, by the application of fan-in and fan-out cones, i.e., FROM-TO cones, the (logic) function under test can be extracted. Furthermore, write bits and/or read bits may be identified. Write bits may serve for determining where to apply constraints, and read bits may identify potential verification gaps, e.g., for applying a path propagation analysis, for example int eh original design entity representing the (overall) IC design. Thus, by way of the structural analysis or structural partitioning a design entity and thus abstraction for formal verification may be determined.

Thus, a new design entity defined by one or more design entity boundaries given as primary inputs and primary outputs of a plurality of interconnected design elements may be obtained. The design entity may be saved and/or serve as an input to a formal verification tool. To summarize, an IC design in the form of a RTL description may be provided or obtained, e.g., together with one or more properties relating to the RTL description. The IC design and the properties may be compiled into a library (element) to be synthesized, e.g., into a netlist, and/or for a formal model to be created. A verification tool may then apply formal methods to find results for the properties being checked. The properties may be proven, violated or inconclusive. These results can be debugged via user interface via which the user is able to view the results of the verification tool and the IC design, e.g., in the RTL description and/or the netlist. It may also be determined which parts of the IC design have been used to obtain the proofs. Additional assertions may be determined in order to check the functionality of parts of the IC design not yet executed or proven.

Now starting from the eventually large formal model, e.g. VLSI design, it is proposed to use structural analysis on said large formal model in order to define the boundary of a function under verification and/or to create a new smaller formal model containing only the (logic) function under verification, and to then use the smaller model to perform formal verification.

As a result, the smallest possible model containing only the function under verification is obtained, i.e., smallest in comparison to black-boxing and/or signal cutting. Plus, an early and systematic identification of needed constraints, by identifying the one or more write bits, is enabled. In addition, an early and systematic identification of verification gaps, by identifying one or more read bits, which can identify unobserved behaviors is achieved. These advantageous are obtained by a structural analysis step during the pre-processing of the IC design in order to create smaller formal models. The design entity may be saved and/or serve as an input to a formal verification tool. For example, as before, the design entity (and respective properties) may be compiled into a library (element), e.g., to be verified and/or synthesized by an EDA tool, in particular a verification tool, such as Questa PropCheck. The results of the verification may be debugged as described herein, and for example visualized in user interface.

Hence, by performing a structural analysis (and by determining the structural coverage) boundaries of a formal verification can be found in order to determine logic elements and, e.g., obtain an improved coverage and/or faster verification for said logic elements. That is, it is ensured that all logic elements in the design entity are used to obtain the proof or result of the verification.

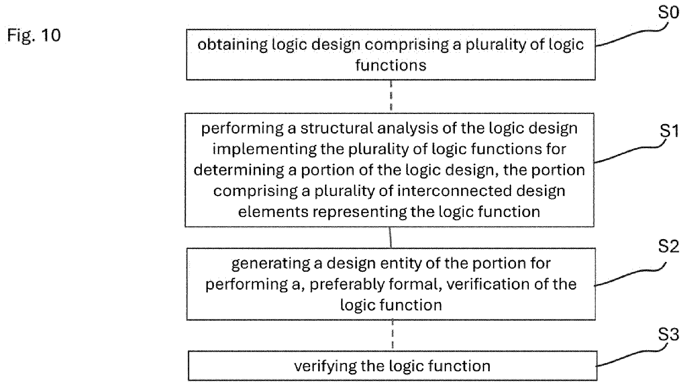

Figures 10 to 14 show exemplary steps S0, S1, S2, S3 of verifying a logic function. Turning to Figure 10. A logic design defines the basic organization of the circuitry of a digital computer. Such a design may be obtained in a step S0. All digital computers are based on a two-valued logic system. Computers perform calculations using components called logic gates (or logic circuits), which are made up of integrated circuits that receive an input signal, process it, and change it into an output signal. The components of the gates pass or block a clock pulse as it travels through them, and the output bits of the gates control other gates or output the result. Following Boolean algebra, there are three basic kinds of logic gates, called AND, which outputs 1 only if both inputs are 1; OR, which outputs 1 if either input is 1; and NOT, which outputs 1 if the input is 0 and outputs 0 if the input is 1. Other logic gates that can be constructed are NAND (NOT-AND), which outputs 1 if either input is 0; NOR (NOT-OR), which outputs 1 only if both inputs are 0; XOR (or EXOR, exclusive OR), which outputs 1 if only one input is 1; and XNOR (or EXNOR, exclusive NOR); which outputs 0 if only one input is 1. By connecting logic gates together, a device can be constructed that can perform basic arithmetic functions. The logic design may comprise the desired functionality of an integrated circuit, IC, or digital system. It involves defining the logical behavior of a design using Boolean algebra, truth tables, state machines, and logic gates before translating it into hardware. A logic design may represent an integrated circuit. A logic design may thus be understood as is a model of computation in which input values proceed through a sequence of gates, each of which computes a function. A logic design may provide a generalization of Boolean circuits and a mathematical model for digital logic circuits. A logic design may be defined by the gates they contain and/or the values the gates can produce.

A logic function refers to a Boolean (or arithmetic) function that defines the relationship between input variables and the resulting output in a digital circuit. It describes how input signals are processed using logic gates (AND, OR, NOT, XOR, etc.), e.g., to produce a specific output or result. A logic design may comprise a plurality of said logic functions.

A logic design of an integrated circuit may be a very-large-scale integration, VLSI, design, e.g., may represent an integrated circuit comprising millions or billions of metal-oxide-semiconductor field-effect transistor, MOS, transistors onto a single chip.

A logic design may thus be stored or loaded by an EDA tool, e.g., a verification tool. Electronic design automation, EDA, also referred to as electronic computer-aided design, ECAD, is a category of software tools for designing electronic systems such as integrated circuits. Such tool may serve for designing, simulating, analysis and/or verification of a logic design.

A structural analysis may be performed in a step S1 and may comprise a syntactic and semantic analysis of a logic design, e.g., in the form of source code, e.g., an RTL description, a netlist or at the gate-level. A structural analysis may serve for determining dependencies within the logic design. Formal verification, on the other hand, establishes the condition under which a timing path exists based on the propagation requirements for the path. These path propagation requirements are then used to prove or disprove constraint properties based on a formal analysis of the design. Structural analysis is fast because it is simple. Formal verification, however, is more complete but also requires more computing resources.

A structural analysis may serve for determining a portion of the logic design. In particular, the portion may comprise plurality of interconnected design elements representing the logic function. Design elements may include one or more of, for example, bits, states, ports, signals, wires, gates or cells.

Subsequently, a design entity of the portion may be generated in a step S2. The design entity may serve for performing a, preferably formal, verification of the logic function. To that end, the design entity may comprise parameters, e.g., in the form of a formal c defining the inputs and/or outputs of the formal coverage boundaries, identifying the inputs and outputs of the design entity, e.g., with in the original design entity based on which the structural analysis is performed. Hence, at first a structural analysis of a logic design (e.g., given in the form of an original design entity) is performed and subsequently a design entity for a subpart or portion of that original logic design is created for performing a (formal) verification of that portion or subpart (only). Said verification may be performed in a step S3, e.g., by a verification tool. A verification tools examines the logical and/or physical representations of the IC to determine if the resultant design is connected correctly and will deliver the required performance. Thus, the design entity may be input and/or processed by the verification tool in order to verify the logic function.

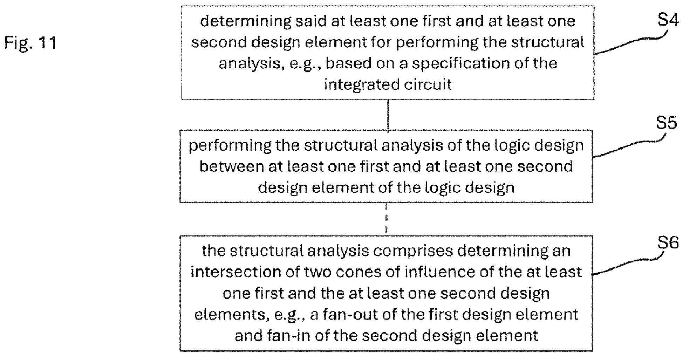

Turning to Figure 11, at least one first and at least one second design element for performing the structural analysis, e.g., based on a specification of the integrated circuit are determined in a step S4. Naturally, design elements such as said core_inputs, s_core_inputs, core_output, and/or s_core_output singals may be chosen as first and second design elements respectively. It should be understood that said core_inputs and said s_core_inputs are the same, i.e., the same signals are applied to the inputs. It is possible to make use of automatized solutions comprising a large language model in order to determine for example based on the specification of the circuit, and e.g., a prompt, the at least one first and at least one second design elements. A large language model, LLM, is a type of machine learning model designed for language processing tasks such as language generation. From European patent application 24206999.5 verification techniques using LLM-based property generation are known. Similarly use can be made of the LLM to identify first and at least one second design elements for performing the structural analysis, e.g., said FROM and/or TO bits, as described herein.

A structural analysis of the logic design between at least one first and at least one second design element of the logic design may be performed in a step S5. Thereby a portion of the logic design between at least one first and at least one second design element of the logic design can be determined. Thus, the resulting portion can be identified and design elements influencing the behavior of (design elements of) the portion which are not the first design element, and design elements influenced by (design elements of) the portion which are not the second design element can be identified. For such design elements constraints can be determined and/or the portion can be cut-off from said design elements influencing the behavior and/or influenced by the behavior. Such design elements may serve as boundary configuration for the formal verification, e.g., by identifying them as primary inputs and/or outputs, as the case may be.

The structural analysis may comprise a cone of influence analysis, e.g., in a step S6. The structural analysis may serve for determining an intersection of two cones of influence of the at least one first and the at least one second design elements, e.g., a fan-out of the first design element and fan-in of the second design element. As before, the intersection of the cones serves for identifying said portion, and the design elements influencing the behavior of (design elements of) the portion which are not the first design element, and design elements influenced by (design elements of) the portion which are not the second design element.

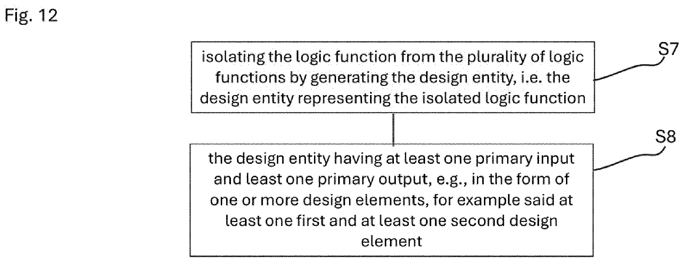

Turning to Figure 12, the logic function may be isolated in a step S7 from the plurality of logic functions by generating the design entity, i.e., the design entity representing the isolated logic function. Said isolation may be achieved by setting a boundary configuration in the (formal) verification tool. Alternatively, the design entity may be stored in a library, as, e.g., described herein.

The design entity may be defined and thus comprise at least one primary input and least one primary output, e.g., in the form of one or more design elements, for example said at least one first and at least one second design element as shown in step S8. This thus enables an accurate separation of the logic function to be verified from the totality of the logic circuit and a useful usage of the computing resources available for the (formal) verification of the design entity generated.

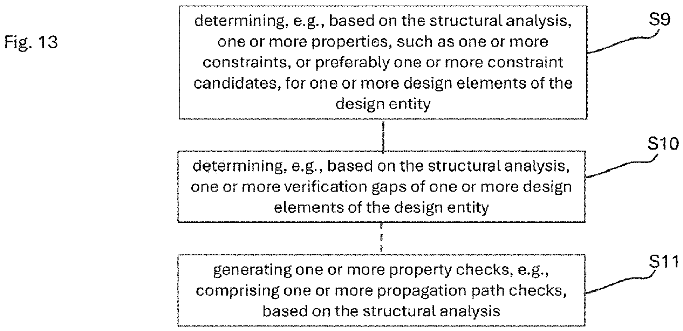

Now turning to Figure 13, one or more properties, such as one or more constraints, or preferably one or more constraint candidates, may be determined in a step S9, e.g., based on the structural analysis, for one or more design elements of the design entity. Such constraints or constraint candidates may be based on properties of the logic circuit, and as, e.g., determined and as described herein, for example for the design elements influencing the behavior of (design elements of) the portion which are not the first design element, and design elements influenced by (design elements of) the portion which are not the second design element.

Such properties or constraints or constraint candidates may serve for determining in a step S10, e.g., based on the structural analysis, one or more verification gaps of one or more design elements of the design entity. Such verification gaps may relate to unused design elements in the logic design and/or the portion thereof. Such verification gaps may also relate to one or more escape paths. An escape path may be given by a signal propagation, where a signal passes through combinational or sequential logic, through the logic design and by way of which an unintended behavior is caused. An escape path may be identified by one or more design elements influenced by (design elements of) the portion which are not the second design element.

Hence, one or more property checks, e.g., comprising one or more propagation path checks, may be generated in a step S11 based on the structural analysis. Based on the design elements influenced by (design elements of) the portion which are not the second design element path checks may be determined in order to verify and/or possible escape paths via which a signal may propagate out of the portion.

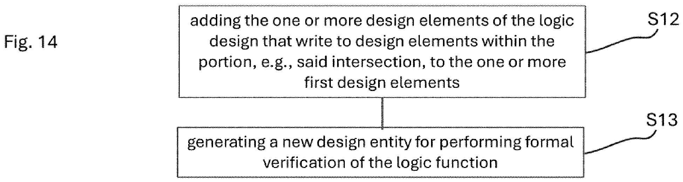

Turning to Figure 14, the one or more design elements of the logic design that write to design elements within the portion, e.g., said intersection, may be added in a step S12 to the one or more first design elements. That is, the design elements influencing the behavior of (design elements of) the portion which are not the first design element may be determined and added to the one or more first design elements. Thereupon, a (formal) verification of the in step S13 newly generated design entity for performing formal verification of the logic function may be performed.

Since one of the bottle necks in (formal) verification is the size of the design that is fed into the verification tool it is proposed to determine a reduced logic design represented by the design entity described herein and to (formally) verify this design entity.

## Claims

1. A, preferably computer-implemented, method of verifying a logic function (230, 230a) of a plurality of logic functions (230, 240, 232, 230a, 240a, 232a) of an integrated circuit (100), e.g., a VLSI design, the method comprising the steps of:
performing a structural analysis of a logic design (101) implementing the plurality of logic functions (230, 240, 232) for determining a portion (102) of the logic design (101), the portion (102) comprising a plurality of interconnected design elements (311, 312, 314, 313) representing the logic function (230, 230a),
generating a design entity (600) of the portion (328) for performing a, preferably formal, verification of the logic function (230).

2. The method according to the preceding claim, further comprising obtaining the implementation of the plurality of logic functions (230, 240, 232, 230a, 240a, 232a) in the form of a logic design (101) representing the integrated circuit (100).

3. The method according to any one of the preceding claims, further comprising performing the structural analysis of the logic design (101) between at least one first and at least one second design element (330,310) of the logic design (101).

4. The method according to any one of the preceding claims, further comprising isolating the logic function (230, 230a) from the plurality of logic functions (230, 240, 232, 230a, 240a, 232a) by generating the design entity (600), i.e., the design entity (600) representing the isolated logic function (230, 230a).

5. The method according to any one of the preceding claims, further comprising obtaining an original design entity comprising the implementation of the plurality of logic functions (230, 240, 232, 230a, 240a, 232a), e.g., of said integrated circuit (100), and generating the design entity (600) by isolating the logic function (230, 230a) from the plurality of logic functions (230, 240, 232, 230a, 240a, 232a), e.g., based on said structural analysis.

6. The method according to any one of the preceding claims, further comprising performing the, e.g., formal, verification, preferably only, and most preferably at first, on the design entity (600) of the logic function (230, 230a), preferably before performing a, e.g., formal, verification of one or more other logic functions (230, 230a) of the plurality of logic functions (230, 240, 232, 230a, 240a, 232a), e.g., of said integrated circuit (100).

7. The method according to any one of the preceding claims, further comprising, determining said at least one first and at least one second design element (330,310) for performing the structural analysis, e.g., based on a specification of the integrated circuit (100).

8. The method according to any one of the preceding claims, further comprising the design entity (600) having at least one primary input and least one primary output, e.g., in the form of one or more design elements, for example said at least one first and at least one second design element (330, 310).

9. The method according to any one of the preceding claims,
wherein the structural analysis comprises determining an intersection (324) of two cones of influence of the at least one first and the at least one second design elements (330, 310), e.g., a fan-out of the first design element and fan-in of the second design element, wherein most preferably the portion (102) is identified by the intersection (324).

10. The method according to any one of the preceding claims, further comprising determining, e.g., based on the structural analysis, one or more properties, such as one or more constraints, or preferably one or more constraint candidates, for one or more design elements (312) of the design entity, i.e. within the portion representing the logic function, e.g., based on one or more design elements (315) outside the portion (324) representing the logic function (230, 230a) driving one or more design elements (312) within the portion (102) representing the logic function, preferably wherein the one or more design elements (315) outside the portion representing the logic function are not the first and/or second design element (330, 310).

11. The method according to any one of the preceding claims, further comprising determining, e.g., based on the structural analysis, one or more verification gaps of one or more design elements (313) of the design entity (600), i.e. within the portion (102) representing the logic function (230, 230a), which design elements (313) within the portion are read by design elements (319) outside the portion (102) representing the logic function, preferably wherein the design elements (319) outside the portion are not the first and/or second design element (330, 310).

12. The method according to any one of the preceding claims, further comprising generating, e.g., by a, in particular formal, verification tool, one or more property checks, e.g., comprising one or more propagation path checks, based on the structural analysis, e.g., by identifying one or more design elements within and/or outside of the portion representing the logic function, e.g., the one or more design elements which read from design elements in the portion, e.g., said intersection.

13. The method according to any one of the preceding claims, further comprising
adding the one or more design elements (315, 319) of the logic design (101) that write to design elements within the portion (102), e.g., said intersection, to the one or more first design elements (330), and/or
generating a new design entity for performing formal verification of the logic function.

14. A computer program, comprising program code that when executed performs the method steps of any one of the preceding claims.

15. An apparatus, preferably comprising a processor and a memory, in particular comprising said computer program, for performing the method steps of any one of the preceding claims 1-13.
